# EUROPEAN PATENT APPLICATION

(11) **EP 0 803 997 A2**
(43) Date of publication of application: **29.10.1997**
(21) Application number: 97660048.6
(22) Date of filing: 22.04.1997
(51) Int. Cl.: H04B 15/04, H04B 1/16

(54) **A method and arrangement for producing a clock frequency in a radio device**

(30) Priority: 26.04.1996 FI 961786
(71) Applicant: NOKIA MOBILE PHONES LTD., 02150 Espoo (FI)
(72) Inventor: Kuiri, Tapio, 90580 Oulu (FI)
(74) Representative: Kupiainen, Juhani Kalervo

(57) **Abstract**

In a radio device, which contains a radio frequency part (1) for transmitting or receiving on several optionally selectable radio channels, each being assigned a frequency band, and a control part or similar part (2, 3) that requires at least one clock frequency for its operation, according to the present invention, for each radio channel, a corresponding frequency is assigned having no harmonic frequency within the frequency band of said radio channel, and said assigned corresponding clock frequency is produced as a response to the selection of a radio channel. An arrangement according to the present invention includes means (5) for producing a clock frequency from several optionally selectable clock frequencies that are selected so that for each radio channel there exists at least one clock frequency having no harmonic frequency that coincides with the frequency band of said radio channel, means (6) for assigning such a clock frequency corresponding to each radio channel and means (3, 6) for controlling the means (5) for producing a clock frequency as a response to the selection of a radio channel, to produce said assigned corresponding clock frequency. The optionally selectable clock frequencies are advantageously produced by means of a programmable phase-locked synthesizer (5), in which a synthesized frequency (CLK) divided by a first divisor (N) is locked to a reference frequency (f_{ref}) divided by a second divisor (R), and into which the stored divisors corresponding to the radio channels can be programmed to produce the assigned clock frequency.

## Description

The present invention relates to the production of a clock frequency in a radio device that transmits or receives on several optionally selectable radio channels, each having its own frequency band. The present invention also relates to the elimination of interference caused on radio channels by harmonic frequencies of a clock frequency.

Modern radio devices usually include control or other parts for which clock frequencies are produced in the devices. For example, in a mobile telephone one or more clock frequencies are produced for the processors and memories of the base frequency part. It has been shown that the harmonic components of clock frequencies may cause interference on radio frequency channels used by the device, even though harmonic frequencies of very high multiples are in question. For example, if the clock frequency is 10 MHz and the radio frequencies that are used are in the range of 900 MHz, the multiple of the harmonic frequencies that coincide with the radio frequencies is in the magnitude of 90. Such interference is possible because the signal levels in the base frequency part are high, several volts, and the waveforms are square. When many changes of state occur at the clock frequency, the signal level of a harmonic frequency of a very high multiple may get high enough to cause interference on a radio channel it coincides with. For example, the noise spectrum of a harmonic frequency of the clock frequency of a digital signal processor may cause interference on several adjacent radio channels.

Problems of this nature have conventionally been solved in radio devices by preventing interference from penetrating RF parts by using carefully-made housings, for example. However, it is often difficult and expensive to realize a housing that provides sufficient protection against interference. Another possibility is to select the clock frequencies so that their harmonic frequencies will not coincide with the transmission and reception frequency range. However, as the clock frequencies usually are small compared to the RF bandwidths, some harmonic frequencies usually appear on some of the radio channels.

The required clock frequency is often produced by means of a crystal oscillator reserved especially for that purpose. In such a case, one suggested solution to the above-mentioned problem is to shift the frequency of the crystal oscillator, if necessary, for example, by decreasing or increasing the load capacitance of the crystal oscillator. However, in this solution the change in the frequency is not precise, causing an error in timebases locked to the crystal frequency, for example, which is hard to control. Neither is this solution possible if the clock frequency of the base frequency part is produced by an RF crystal, because the RF crystal frequency should be shifted, which would also cause a shift in the RF frequencies.

The purpose of the present invention is to present a simple and advantageous solution to the problem described above.

A method for producing a clock frequency in a radio device according to the present invention, which includes:
a radio frequency part for transmitting or receiving on several optionally selectable radio channels, each of which is assigned a frequency band,
a base frequency part that requires a clock frequency for timing of its operation,
is characterized in that, in said method:
corresponding to each radio channel a clock frequency is assigned that has no harmonic frequency within the frequency band of said radio channel, and
in response to the selection of said radio channel said assigned corresponding clock frequency is produced.

It is advantageous to assign the clock frequencies so that, corresponding to each radio channel, there exists at least one clock frequency that has no harmonic frequency or no interference spectrum, which is created when said frequency is used as a clock frequency, within the frequency band of said radio channel.

In one advantageous embodiment of the method according to the present invention, a suitable clock frequency is assigned as a default frequency and another separate clock frequency corresponding to the radio channel is assigned only if a harmonic frequency of the default frequency causes interference on the radio channel. A separately assigned clock frequency is produced only for such channels, and the default frequency is produced otherwise.

A clock frequency can be assigned corresponding to each radio channel by storing information that indicates the clock frequency together with information that indicates the channel in the radio device.

An arrangement for producing a clock frequency in a radio device according to the present invention, which includes:
a radio frequency part for transmitting or receiving on several optionally selectable radio channels, each of which is assigned a frequency band,
a base frequency part that requires a clock frequency for timing of its operation,
is characterized in that it includes:
means for producing a clock frequency from several optionally selectable clock frequencies that are selected so that, corresponding to each radio channel, there exists at least one clock frequency that has no harmonic frequency within the frequency band of said radio channel, and
means for assigning, corresponding to each radio channel, a clock frequency that has no harmonic frequency within the frequency band of said radio channel, and
means for controlling said means for producing a clock frequency in response to the selection of a radio channel, in order to produce said corresponding assigned clock frequency.

The means for producing a clock frequency corresponding to each radio channel may include stored information, such as a table stored in memory, in which a corresponding clock frequency is connected to one or more radio channels.

The means for producing a clock frequency are advantageously controlled by means of the CPU of the radio device.

In an advantageous embodiment of the arrangement according to the present invention, the clock frequencies are produced by means of a frequency synthesizer based on a phase-locked loop, which receives a reference frequency and outputs a synthesized clock frequency and in which the reference frequency is connected to a phase comparator via a first programmable frequency divider and the synthesized frequency is connected via a second frequency divider. In an alternative embodiment, the reference frequency is obtained from a crystal oscillator of the radio frequency part. In order to assign a frequency and control the frequency divider to cause it to produce the assigned clock frequency, a table connecting corresponding divisors, which are to be programmed into the dividers of the synthesizer, to one or more radio channels can be stored in memory.

Because it is not necessary to find a single suitable clock frequency in the solution according to the present invention, frequencies can be selected in the base frequency part more freely than before. Previously it has been necessary to especially avoid causing interference in the receiver band, and it has possibly been necessary to select clock frequencies with harmonic frequencies within the transmission band, causing false transmissions. On the other hand, it is now possible to use a clock frequency that has a harmonic frequency within one of the reception channels, as it is possible to use another optionally selectable clock frequency for said channel. The present invention can be advantageously realized by means of a phase-locked synthesizer provided with programable frequency dividers, and particularly advantageously by taking the reference frequency from an existing crystal oscillator, such as that of the radio frequency part. A noticeable savings is achieved if a separate crystal and crystal oscillator are not needed. On the other hand, a phase-locked synthesizer can be realized as part of an integrated circuit, which is advantageous with regard to space saving and cost. Several frequencies, such as the clock frequencies of the digital signal processor and CPU, can be produced from the same crystal oscillator frequency, advantageously the reference frequency of the RF part, by means of different phase-locked synthesizers integrated in the same circuit.

Embodiments of the present invention described above and other embodiments are described in more detail below with references to the enclosed drawings.
Figure 1 is a flow chart showing an embodiment of a method for producing a clock frequency according to the present invention,
Figure 2 presents a block diagram of an embodiment of an arrangement according to the present invention,
Figure 3 presents in more detail a phase-locked loop included in the embodiment of figure 2 and
Figure 4 presents a flow chart of an embodiment of a method according to the present invention that can be realized by means of the arrangement of figures 2 and 3.

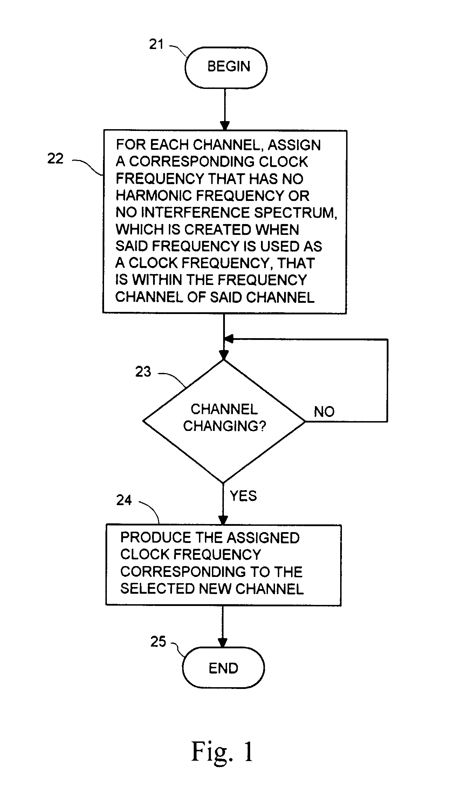

Figure 1 is a flow chart that illustrates a method for producing a clock frequency according to the present invention in a radio device that receives on several optionally selectable radio channels, each of which is assigned a frequency band. In phase 22 of the method, corresponding to each radio channel a clock frequency is assigned that has no harmonic frequency or no interference spectrum, which is created when said frequency is used as a clock frequency, that is within the frequency band of said radio channel. In most cases, it suffices to assign two frequencies, one of which can be a default frequency that is used on all radio channels that a harmonic frequency or interference spectrum of said clock frequency does not cause interference in. An alternative frequency is assigned that is suitable for use in the other radio channels. Phase 23 "monitors" whether or not the radio frequency channel is being changed, or simply receives information indicating the channel is being changed. If there is no change, "monitoring" is continued. If the channel is being changed, a new clock frequency corresponding to the selected new channel is produced in phase 24. Rather than actually continuously monitoring the channel change, it is advantageous to arrange the operation so that information is always received regarding the channel change and what channel is selected, so that a new clock frequency corresponding to the selected new channel can be produced.

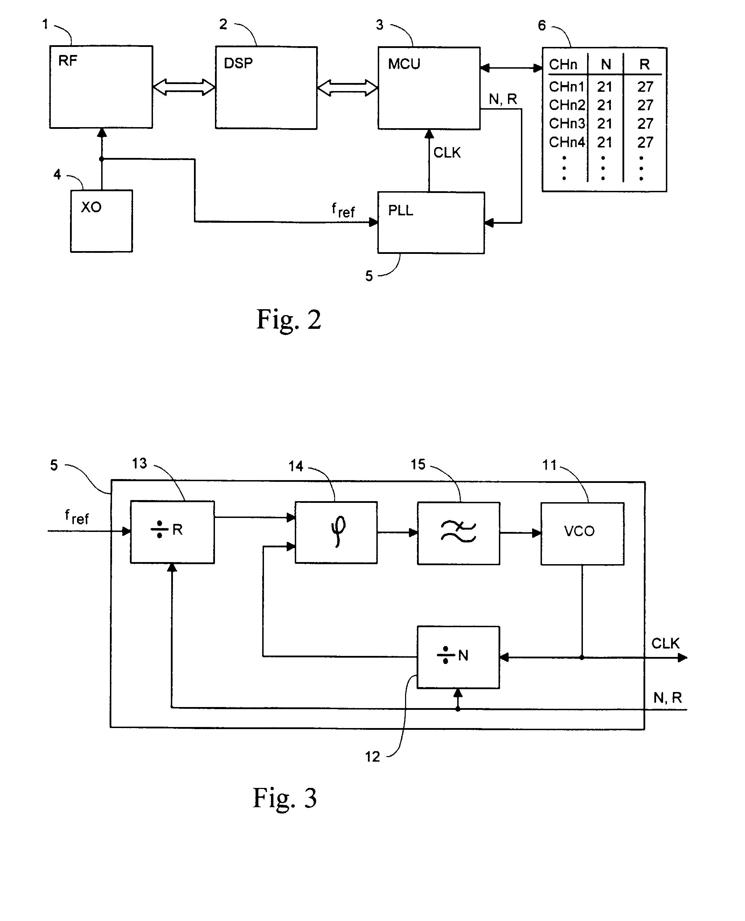

Figures 2 and 3 present an advantageous embodiment of an arrangement according to the present invention. A radio device, such as a mobile telephone, contains a radio frequency part 1 and a base frequency part that comprises, for example, a digital signal processor 2 and a CPU 3. In this example, a clock frequency CLK is produced for the processor 3 by means of an arrangement according to the present invention, which includes a phase-locked loop 5 that receives a reference frequency f_{ref} from a crystal oscillator 4 of an RF part. The phase-locked loop 5, whose operation and realization is known, is presented in more detail in figure 2. It includes a voltage-controlled oscillator 11, which produces the clock frequency CLK output by the loop. The oscillator 11 receives a control voltage from a phase comparator 14 via a loop filter 15. The reference frequency f_{ref} divided by a divisor R on the one hand and the clock frequency CLK output by the oscillator divided by a divisor N on the other hand are brought to the phase comparator. Frequency division is performed in corresponding programmable frequency dividers 13 and 12, with control signals N, R being brought to the phase-locked loop for the purpose of setting the divisors. The phase-locked loop locks the oscillator frequency divided by N to the reference frequency divided by R, and divisors N and R are selected so that suitable optional frequencies can be produced by changing N and R. In the primary embodiment, only two optional frequencies are produced. As a rule, a suitably selected frequency, a default frequency, is used, and another frequency close by is used on channels that a harmonic frequency of the default frequency causes interference in. The divisors that produce the default clock frequency are usually programmed into the frequency dividers 12 and 13, and, correspondingly, the other divisors are programmed for channels that a harmonic frequency of the default frequency causes interference in.

In the embodiment shown in figure 2, the arrangement according to the present invention includes a software table 6 that has a list of channels CHn that a harmonic frequency of a normally used clock frequency or an interference spectrum, which is created when said frequency is used as a clock frequency, will coincide with. Corresponding to said channels, the table contains divisors N and R, which in this case are divisors that produce the same alternative clock frequency for all the channels with interference. There may be several alternative divisors, and hence, several alternative clock frequencies. The CPU 3 of a radio device, such as a mobile telephone, is always aware of a channel change and the radio channel in use. During a channel change the CPU 3 checks if the selected channel is in the table 6, which would mean it is a channel susceptible to interference. If it isn't, the CPU outputs the divisors N and R that produce the default clock frequency to the phase-locked loop. If the channel is susceptible to interference, the CPU 3 outputs the divisors N and R corresponding to said channel in table 6 to the loop synthesizer 5.

It is expedient to use the method and arrangement according to the present invention in radio devices, such as mobile telephones, which contain a large number of optionally selectable radio frequency channels. The portion of all channels that are susceptible to interference by a harmonic frequency of the clock frequency is small. In such a case it is advantageous to realize the present invention in the manner illustrated in figure 1, in which only the interference-prone channels are listed in a table or otherwise indicated so that another clock frequency can be selected for said channels. For example, in a GSM system the reception frequency band of a mobile telephone may be 935 ... 960 MHz, which is 124 radio frequency channels 200 KHz wide, and one CPU clock frequency that is used is 13 MHz. In that case there would be only two interference-prone reception channels, as the 72nd harmonic frequency of the 13 MHz frequency would coincide with the 5th channel and the 73rd harmonic with the 70th channel. Possible blocking of the channel could be prevented by changing the clock frequency for these channels to 13,2 MHz, for example, by means of a phase-locked loop with programmable frequency dividers.

An example of how a frequency is produced is examined in the following, with references to figures 2 and 3. The radio device is a digital mobile telephone that has a CPU 3 with a clock frequency of 10 MHz. An RF crystal oscillator 4 produces a reference frequency f_{ref} of 13 MHz. Normally, the divisor N = 20 and the divisor R = 26. Let us suppose that a base station asks the mobile telephone to listen to a channel on a 940 MHz radio frequency channel whose frequency band is 939,9 ... 940,1 MHz. Now, the 94th harmonic frequency of the 10 MHz clock frequency is 94 x 10 MHz = 940 MHz, which is within this frequency band. Therefore, this radio frequency channel or the channels located on this frequency channel are assigned other divisors N = 21 and R = 27 from table 6. Now, the clock frequency CLK is 13 MHz / 27 x 21 = 10,111... MHz. The harmonic frequencies of this frequency that are the closest to said radio channel are 92 x 10,111... MHz = 930,222... MHz and 93 x 10,111... MHz = 940,333... MHz, which are outside the received radio frequency band.

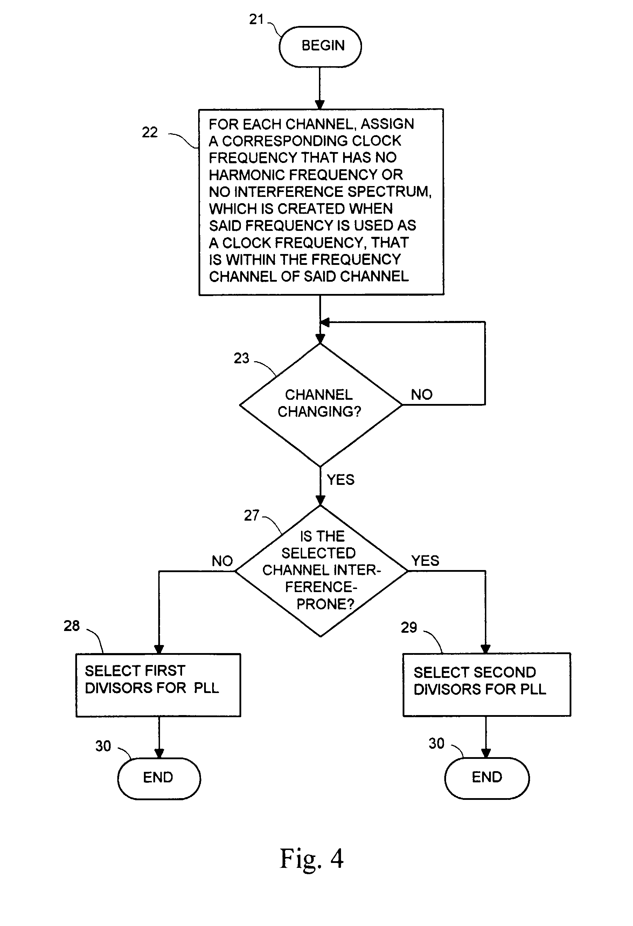

The flow chart in figure 4 illustrates an embodiment of the method according to the present invention corresponding to the arrangement presented in figures 2 and 3. In phase 22 of the method a frequency corresponding to each radio channel is assigned that has no harmonic frequency or no interference spectrum, which is created when said frequency is used as a clock frequency, that is within the frequency band of said radio channel. Phase 23 "monitors" whether or not the radio frequency channel is being changed, or simply receives information indicating the channel is being changed and what the new selected channel is. In the course of normal operation, the control part of the radio device is always aware of the channel being used for transmission or reception and when a channel change will take place and to what channel in the radio device the change will be directed to. If the channel is being changed, phase 27 checks if the new selected channel is susceptible to interference, i.e., is it listed in the table of channels that coincide with a harmonic frequency of the clock frequency or its interference spectrum. If it isn't listed, the normally used divisors 12 and 13 of the programmable dividers of the phase-locked loop 5 that produce the default clock frequency are selected. If the channel is susceptible to interference, other divisors are programmed into the dividers of the phase-locked loop. In other words, divisors N = 21 and R = 27 are used in place of the normally used divisors N = 20 and R = 26. The control can be aware of which divisors are in the dividers at a given moment or which divisors were last programmed into the dividers, programming new divisors into the dividers only if they must be changed. In a mobile telepone system in which a base station assigns a channel to the telephone, it is advantageous to arrange the operation so that whenever the channel is assigned, the mobile telephone is made to check if the channel is susceptible to interference and operate accordingly.

The table of interference-prone channels presented in figure 1 is easy to realize as part of the software that controls the operation of a radio device. A person skilled in the art understands that the details of such a table or similar function and the corresponding assignment of new divisors to the programmable frequency dividers of a phase-locked loop can be realized in many ways. It is also clear that the many different clock frequencies that may be used in a radio device, such as the different clock frequencies of the CPU and digital signal processor, can each be realized with their own programmable phase-locked loop synthesizer that is controlled as shown in figure 1 or in a similar manner. The phase-locked loop synthesizers needed to produce the different frequencies can be integrated into the same integrated circuit.

The changing of clock frequencies for interference-prone channels must be taken into consideration when arranging functions that require precise timing. Calculation of timing can be modified to take into account the periodic change in clock frequency, or the timing of operations, such as A/D conversions, can be directly based on the frequency of the RF crystal. Also, the operation of parts that use clock frequencies must allow for a larger margin of variation in the clock frequency.

The present invention is not limited to the presented examples, but can vary to the extent allowed by the enclosed claims.

## Claims

1. A method for producing a clock frequency in a radio device, which includes:
a radio frequency part (1) for transmitting or receiving on several optionally selectable radio channels, each of which is assigned a frequency band,
a base frequency part (2) that requires a clock frequency for timing of its operation,
**characterized** in that, in said method:
corresponding to each radio channel a clock frequency is assigned having no harmonic frequency that is within the frequency band of said radio channel, and
in response to the selection of a radio channel said assigned corresponding clock frequency is produced.

2. The method for producing a clock frequency in a radio device according to claim 1, in which operation timed by the clock frequency produces interference spectra located around the clock frequency and its harmonic frequencies, **characterized** in that the clock frequencies are assigned so that for each radio channel there exists at least one clock frequency that has no harmonic frequency or no interference spectrum, which is created when said frequency is used as a clock frequency, that is within the frequency band of said radio channel.

3. The method according to claim 1 or 2, **characterized** in that, in said method:
one of several clock frequencies is assigned to be a default frequency,
a clock frequency is assigned separately for a radio channel only if a harmonic frequency of the default frequency or an interference spectrum, which is created when said frequency is used as a clock frequency, is within the frequency band of said radio channel, and
the default clock frequency is produced in response to the selection of a radio channel, if there is no separately assigned clock frequency related to said radio channel, and a separately assigned clock frequency is produced otherwise.

4. The method according to any preceding claim, **characterized** in that a clock frequency is assigned for each radio channel by storing in the radio device the information indicating the clock frequency (N, R) in connection with the information indicating the channel (CHn).

5. An arrangement for producing a clock frequency in a radio device, which includes:
a radio frequency part (1) for transmitting or receiving on several optionally selectable radio channels, each of which is assigned a frequency band,
a base frequency part (2) that requires a clock frequency for timing of its operation,
**characterized** in that, said arrangement includes:
means (5) for producing a clock frequency from several optionally selectable clock frequencies that are selected so that a clock frequency corresponding to each radio channel exists that has no harmonic frequency within the frequency band of said radio channel,
means (6) for assigning a clock frequency for each radio channel that has no harmonic frequency within the frequency band of said radio channel, and
means (3, 6) for controlling the means (5) for producing a clock frequency in response to the selection of the radio channel, to produce the clock frequency assigned for the radio channel.

6. The arrangement according to claim 5, **characterized** in that the means for assigning a clock frequency corresponding to each radio channel include stored information (6), which connect the corresponding clock frequency to one or more radio channels (CHn).

7. The arrangement according to claim 5 or 6, **characterized** in that the means for controlling the means (5) for producing a clock frequency inlude a CPU (3) of the radio device.

8. The arrangement according to one of the claims 5 - 7, **characterized** in that the means (5) for producing a clock frequency include a frequency synthesizer based on a phase-locked loop, which receives a reference frequency (f_{ref}) and outputs a synthesized clock frequency (CLK) and includes:
a first programmable frequency divider (13), that has a first programmable divisor (R),
a second programmable frequency divider (12), that has a second programmable divisor (N), and
a phase comparator (14),
and in which the reference frequency (f_{ref}) is connected to the phase comparator (14) via the first programmable frequency divider (13) and the synthesized clock frequency (CLK) is connected to the phase comparator (14) via the second frequency divider (12).

9. The arrangement according to claim 8, **characterized** in that the reference frequency (f_{ref}) is obtained from a crystal oscillator (4) of the radio frequency part.

10. The arrangement according to claims 8 or 9, **characterized** in that it includes stored information (6) by which corresponding divisors (N, R) are connected to one or more radio channels (CHn), which divisors are programmed into the dividers (12, 13) of the synthesizer to produce the assigned clock frequency.
